# DEMANDE DE BREVET EUROPEEN

(11) **EP 4 386 860 A1**
(43) Date de publication de la demande: **19.06.2024**
(21) Numéro de dépôt: 23213901.4
(22) Date de dépôt: 04.12.2023
(51) Int. Cl.: H01L 29/778, H01L 21/337, H01L 23/29, H01L 23/31, H01L 29/41, H01L 29/10, H01L 29/20

(54) **TRANSISTOR HEMT**

(30) Priorité: 13.12.2022 FR 2213256
(71) Demandeur: STMicroelectronics International N.V., 1228 Plan-les-Ouates, Geneva (CH)
(72) Inventeur: CONSTANT, Aurore, 37100 TOURS (FR); IUCOLANO, Ferdinando, 95030 GRAVINA DI CATANIA (IT); TRINGALI, Cristina, 96011 AUGUSTA (IT)
(74) Mandataire: Thibon, Laurent

(57) **Abrégé**

La présente description concerne un transistor HEMT comportant :
- une première couche semiconductrice (13) ;
- une grille (15) disposée sur une première face de la première couche semiconductrice (13) ;
- une première couche de passivation (17) en un premier matériau sur les flancs de la grille, la première couche de passivation se prolongeant en outre sur une première partie de ladite face de la première couche semiconductrice ; et
- une deuxième couche de passivation (19) en un deuxième matériau différent du premier matériau sur une deuxième partie de ladite face de la première couche semiconductrice à côté de la première couche de passivation.

## Description

### Domaine technique

La présente description concerne de façon générale le domaine des transistors et plus particulièrement le domaine des transistors à haute mobilité électronique aussi appelés HEMT (de l'anglais "High Electron Mobility Transistor").

### Technique antérieure

Les transistors HEMT reposent sur une hétérojonction en surface de laquelle se forme un gaz bidimensionnel d'électrons appelé 2DEG.

Il existe un besoin d'amélioration des transistors HEMT et de leurs procédés de fabrication.

### Résumé de l'invention

Pour cela, un mode de réalisation prévoit un transistor HEMT comportant :
- une première couche semiconductrice ;
- une grille disposée sur une première face de la première couche semiconductrice ;
- une première couche de passivation en un premier matériau sur les flancs de la grille, la première couche de passivation se prolongeant en outre sur une première partie de ladite face de la première couche semiconductrice ; et
- une deuxième couche de passivation en un deuxième matériau différent du premier matériau sur une deuxième partie de ladite face de la première couche semiconductrice à côté de la première couche de passivation.

Selon un mode de réalisation, la première couche semiconductrice est à base de nitrure de gallium.

Selon un mode de réalisation, la première couche semiconductrice est en nitrure d'aluminium-gallium.

Selon un mode de réalisation, la première couche de passivation est en alumine.

Selon un mode de réalisation, la deuxième couche de passivation est en nitrure d'aluminium.

Selon un mode de réalisation, le transistor comporte une deuxième couche semiconductrice en contact avec une deuxième face de la première couche semiconductrice, opposée à la première face.

Selon un mode de réalisation, la deuxième couche semiconductrice est en nitrure de gallium.

Selon un mode de réalisation, le transistor comporte une métallisation de contact de source et une métallisation de contact de drain, disposées respectivement de part et d'autre de la grille.

Selon un mode de réalisation, la couche de passivation s'étend latéralement depuis la grille en direction de la métallisation de contact de drain, sur une partie seulement de la surface entre la grille et la métallisation de contact de drain.

Selon un mode de réalisation, la couche de passivation s'étend latéralement depuis la grille jusqu'à la métallisation de contact de source.

Selon un mode de réalisation, la deuxième couche de passivation s'étend latéralement depuis un bord de la première couche de passivation situé entre la grille et la métallisation de contact de drain, jusqu'à la métallisation de contact de drain.

Selon un mode de réalisation, la première couche de passivation est recouverte d'une couche d'isolation.

Selon un mode de réalisation, la deuxième couche de passivation recouvre le flanc de la couche isolante situé entre la grille et la métallisation de contact de drain et se prolonge sur une partie de la couche d'isolation en direction de la grille.

Un autre mode de réalisation prévoit un procédé de formation d'un transistor HEMT comportant les étapes successives suivantes :
a) former une première couche semiconductrice ;
b) former une grille sur une première face de la première couche semiconductrice ;
c) former une première couche de passivation en un premier matériau sur les flancs de la grille, la première couche de passivation se prolongeant en outre sur une première partie de ladite face de la première couche semiconductrice ; et
d) former une deuxième couche de passivation en un deuxième matériau différent du premier matériau sur une deuxième partie de ladite face de la première couche semiconductrice à côté de la première couche de passivation.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un transistor HEMT selon un mode de réalisation ;
la figure 2A, la figure 2B, la figure 2C, la figure 2D, la figure 2E, la figure 2F, la figure 2G, la figure 2H et la figure 2I sont des vues en coupe illustrant des étapes d'un exemple d'un procédé de fabrication du transistor HEMT illustré en figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications que peuvent avoir les transistors HEMT décrits ne sont pas détaillées, les modes de réalisation étant compatibles avec les applications usuelles des transistors HEMT. On s'intéresse ici tout particulièrement au domaine des transistors HEMT dits de puissance, capables de tenir des tensions relativement élevées à l'état bloqué, par exemple des tensions de l'ordre de 100 à 650 volts.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

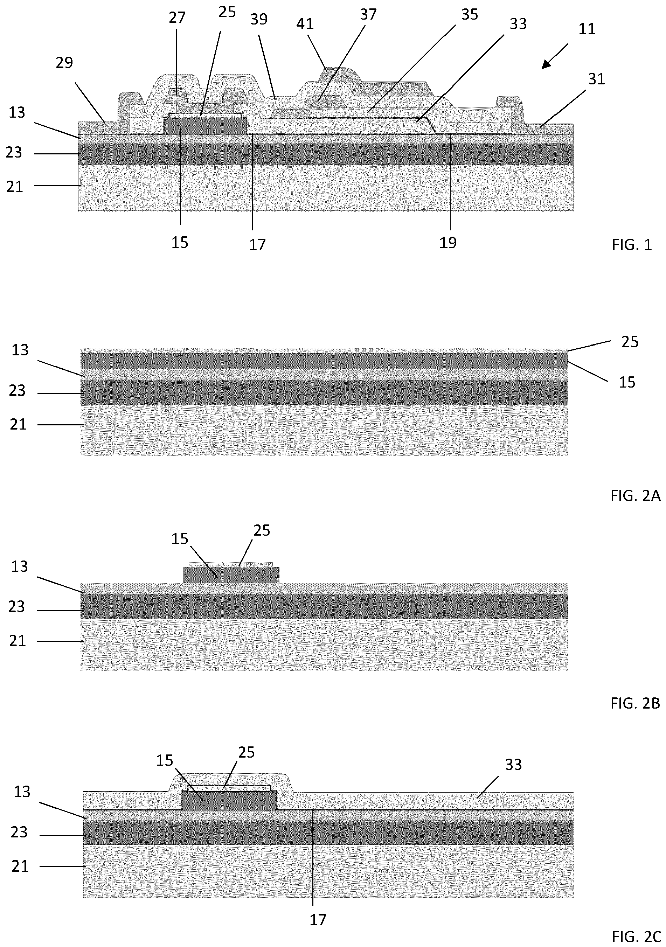

La figure 1 est une vue en coupe, partielle et schématique, d'un exemple d'un transistor HEMT 11 selon un mode de réalisation.

Le transistor HEMT 11 comporte une première couche semiconductrice 13, disposée sur une deuxième couche conductrice 23. La couche semiconductrice 13 est par exemple en contact, par sa face inférieure, avec la face supérieure de la couche conductrice 23. A titre d'exemple, l'empilement comprenant la couche semiconductrice 13 et la couche semiconductrice 23 repose sur un substrat 21. La couche semiconductrice 23 est par exemple en contact, par sa face inférieure, avec la face supérieure du substrat 21. L'interface entre la première couche semiconductrice 13 et la deuxième couche semiconductrice 23 définit une hétérojonction à la surface de laquelle un gaz bidimensionnel d'électrons 2DEG aussi appelé canal d'électrons est formé.

Les couches semiconductrices 13 et 23 sont par exemple en des matériaux semiconducteurs de type III-V, par exemple à base de nitrure de gallium (GaN). La couche semiconductrice 13 est par exemple en nitrure d'aluminium-gallium (AlGaN). La couche semiconductrice 23 est par exemple en nitrure de gallium.

A titre d'exemple, le substrat 21 est en un matériau semiconducteur. Le substrat 21 est par exemple en silicium, ou en carbure de silicium. En variante, le substrat 21 est en nitrure d'aluminium. Le substrat 21 comprend par exemple, du côté de sa face supérieure, une couche tampon ("buffer layer" en anglais), non détaillée sur les figures, par exemple en nitrure de gallium. La couche tampon est par exemple en contact, par sa face supérieure, avec la face inférieure de la couche semiconductrice 23.

Le transistor HEMT 11 comporte une grille 15 sur la face supérieure de la couche semiconductrice 13. La grille 15 est par exemple en contact, par sa face inférieure, avec la face supérieure de la couche semiconductrice 13.

La grille 15 est par exemple en un matériau semiconducteur, par exemple en un matériau semiconducteur de type III-V, par exemple en nitrure de gallium, par exemple dopé de type P.

A titre d'exemple, le transistor HEMT 11 comprend, en outre, une métallisation de contact de source 29 et une métallisation de contact de drain 31. A titre d'exemple, les métallisations de contact 29 et 31 sont à base de titane, de nitrure de titane et/ou d'un alliage d'aluminium et de cuivre. Les métallisations de contact de source 29 et de drain 31 définissent par exemple chacune un contact ohmique avec la couche semiconductrice 13. Les métallisations de contact 29 et 31 sont par exemple situées sur et en contact avec la couche semiconductrice 13, de part et d'autre de la grille 15.

Le transistor HEMT 11 comporte, de plus, une première couche de passivation 17 en un premier matériau recouvrant les flancs de la grille 15 et se prolongeant sur une partie de la face supérieure de la première couche semiconductrice 13. A titre d'exemple, la couche de passivation 17 est en contact, par sa face inférieure, avec la face supérieure de la couche semiconductrice 13. Dans le mode de réalisation de la figure 1, la couche de passivation 17 recouvre une partie seulement de la face supérieure de la couche semiconductrice 13, située à côté de la grille 15, par exemple à la périphérie de la grille 15. Plus particulièrement, dans cet exemple, la couche de passivation 17 s'étend latéralement depuis la grille 15 en direction de la métallisation de contact de drain 31, sur une partie seulement de la surface entre la grille 15 et la métallisation de contact de drain 31. Autrement dit, la couche de passivation 17 ne s'étend pas jusqu'à la métallisation de contact de drain 17. Dans cet exemple, la couche de passivation 17 s'étend en outre latéralement depuis la grille 15 jusqu'à la métallisation de contact de source 29.

A titre d'exemple, la couche de passivation 17 recouvre, en outre, une partie périphérique de la face supérieure de la grille 15.

Le transistor HEMT 11 comporte, de plus, une deuxième couche de passivation 19 en un deuxième matériau différent du matériau de la couche 17. La deuxième couche de passivation 19 est disposée sur une autre partie de la face supérieure de la couche semiconductrice 13. A titre d'exemple, la couche de passivation 19 est en contact avec la face supérieure de la première couche semiconductrice 13. Plus précisément, la couche de passivation 19 est formée à côté de la couche de passivation 17 et recouvre une partie de la couche semiconductrice 13 non recouverte par la couche de passivation 17. Les couches de passivation 17 et 19 sont par exemple en contact par leurs flancs. Dans l'exemple représenté, la couche de passivation 19 s'étend latéralement depuis le bord de la couche de passivation 17 situé entre la grille 15 et la métallisation de contact de drain 31, jusqu'à la métallisation de contact de drain 31.

Les couches de passivation 17 et 19 ont par exemple chacune une épaisseur comprise entre 2 nm et 20 nm, par exemple comprise entre 5 nm et 10 nm. Les couches de passivation 17 et 19 ont par exemple sensiblement la même épaisseur.

La couche de passivation 17 est par exemple en un matériau diélectrique, par exemple en alumine (Al₂O₃) ou en difluorooxonium (Hf₂O). La couche de passivation 19 est par exemple en un autre matériau diélectrique, par exemple en nitrure d'aluminium (AlN) ou en nitrure de silicium (SiN).

A titre d'exemple, la grille 15 est surmontée d'une couche 25, optionnelle, en un matériau métallique, par exemple à base de nitrure de titane. La couche 25 est par exemple en contact avec la grille 15. La couche métallique 25 recouvre par exemple toute la surface de la face supérieure de la grille 15. En variante, la couche métallique 25 s'étend sur une partie centrale seulement de la surface supérieure de la grille 15, de sorte qu'une partie périphérique de la face supérieure de la grille 15 ne soit pas recouverte par la couche métallique 25. La couche de passivation 17 s'étend par exemple latéralement jusqu'à la couche métallique 25.

La couche 25 est par exemple surmontée par une métallisation de contact de grille 27 et est, par exemple, en contact avec celle-ci. A titre d'exemple, la métallisation de contact de grille 27 est à base de nitrure de titane et/ou d'un alliage d'aluminium et de cuivre.

Le transistor HEMT 11 comprend par exemple plusieurs niveaux de couches isolantes dans, et par exemple sur, lesquelles sont formées des métallisations.

A titre d'exemple, le transistor HEMT 11 comprend une première couche isolante 33 sur et en contact avec la face supérieure de la couche de passivation 17. A titre d'exemple, la couche isolante 33 recouvre l'ensemble de la surface de la couche de passivation 17, et ne recouvre pas la couche de passivation 19. La couche isolante 33 est par exemple ouverte en vis-à-vis d'une partie centrale de la face supérieure de la grille 15 de façon à être traversée par la métallisation de contact de grille 27. La couche isolante 33 est par exemple en un matériau diélectrique, par exemple en un oxyde, par exemple en dioxyde de silicium (SiO₂).

A titre d'exemple, la couche de passivation 19 recouvre le flanc de la couche isolante 33 situé entre la grille 15 et la métallisation de contact de drain 31, et se prolonge sur une partie de la couche d'isolation 33 en direction de la grille 15. Ainsi, en partant de la métallisation de contact de drain 31, la couche de passivation 19 recouvre la partie de la face supérieure de la couche semiconductrice 13 située entre la métallisation de contact de drain 31 et la couche de passivation 17, puis se prolonge au-dessus de la couche isolante 33, de sorte qu'une partie de la couche de passivation 19 soit située en vis-à-vis de la couche de passivation 17 et séparée par celle-ci par la couche isolante 33.

A titre d'exemple, le transistor HEMT 11 comprend une deuxième couche isolante 35 sur et en contact avec la face supérieure de la couche de passivation 19. A titre d'exemple, la couche isolante 35 a un flanc en contact avec la métallisation de contact de drain 31 et s'étend en direction de la métallisation de contact de source 29. A titre d'exemple, la couche isolante 35 recouvre, par exemple exclusivement, l'ensemble de la surface de la couche de passivation 19. La couche isolante 35 s'étend ainsi par exemple sur la partie de la face supérieure de la couche semiconductrice 13 non recouverte par la couche isolante 33 et sur la partie périphérique de la couche isolante 33. La couche isolante 35 est par exemple en un matériau diélectrique, par exemple en nitrure de silicium (SiN) ou en un oxyde, par exemple en dioxyde de silicium (SiO₂).

A titre d'exemple, le transistor HEMT 11 comprend une région 37 s'étendant simultanément sur une partie de la surface de la première couche isolante 33 et sur une partie de la surface de la deuxième couche isolante 35. La région métallique 37 est donc disposé sur deux niveaux différents de couches isolantes. A titre d'exemple, la région métallique 37 est à base de nitrure de titane et/ou d'un alliage d'aluminium et de cuivre. La région métallique 37 est par exemple en le même matériau que la métallisation de contact de grille 27.

Le transistor HEMT 11 peut comprendre une troisième couche isolante 39 recouvrant l'ensemble de la structure à l'exception des métallisations de contact de source 29 et drain 31. La troisième couche isolante 39 est, par exemple en le même matériau que les couches isolantes 33 et 35. Le transistor HEMT 11 illustré en figure 1 comprend une région métallique 41 formée sur la couche isolante 39. A titre d'exemple, la région métallique 41 est en le même matériau que la région métallique 37.

Les régions métalliques 37 et 41 ont par exemple pour fonction de modifier le profil de la distribution du champ électrique du bord de la grille, situé du côté du drain (le bord droit de la grille en figure 1), et de réduire le pic du champ électrique critique, augmentant ainsi la tension d'avalanche. Les régions métalliques 37 et 41 sont par exemple appelées "field plates".

Dans le transistor de la figure 1, le canal 2DEG est par exemple normalement fermé ("normally-off" en anglais), c'est-à-dire qu'il est interrompu sous la grille 15 ce qui empêche la circulation d'un courant entre la source et le drain du transistor. On dit alors que le transistor est à l'état bloqué. Le canal peut être rétabli (c'est à dire rendu passant) par la polarisation de la grille 15. Dans ce cas, un courant peut s'établir entre la source et le drain du transistor. On dit alors que le transistor est à l'état fermé ou passant. Les modes de réalisation décrits peuvent également s'appliquer à des transistors normalement ouverts ("normally-on" en anglais).

La présence des couches de passivation 17 et 19 permet la protection de la surface supérieure de la couche semiconductrice 13 sur laquelle des liaisons pendantes peuvent être présentes et susceptibles de générer des courants de fuite et/ou une diminution de la tenue en tension du transistor. Les couches de passivation 17 et 19 comblent ces liaisons afin de rendre la surface de la couche semiconductrice 13 électriquement inactive.

Les couches de passivation 17 et 19 permettent également de protéger la couche semiconductrice 13 contre l'oxydation et d'améliorer son état de surface auquel le canal 2DEG est sensible.

Dans le mode de réalisation de la figure 1, la prévision de deux couches de passivation 17 et 19 de natures distinctes entre la grille et le drain du transistor permet avantageusement d'améliorer le compromis entre la résistance à l'état passant du transistor et les courants de fuite à l'état bloqué.

La première couche de passivation 17, et plus particulièrement la partie de la couche de passivation 17 située sur les flancs de la grille 15, permet d'augmenter la résistivité du canal 2DEG sous et autour de la grille, ce qui engendre une diminution du champ électrique formé au coin de la grille 15, et ainsi une diminution des courants de fuite.

La deuxième couche de passivation 19 permet quant à elle l'apport de charges positives à l'interface entre la couche de passivation et la première couche semiconductrice 13, ce qui augmente localement la densité électronique dans le canal 2DEG, et ainsi en diminue localement la résistivité du canal 2DEG.

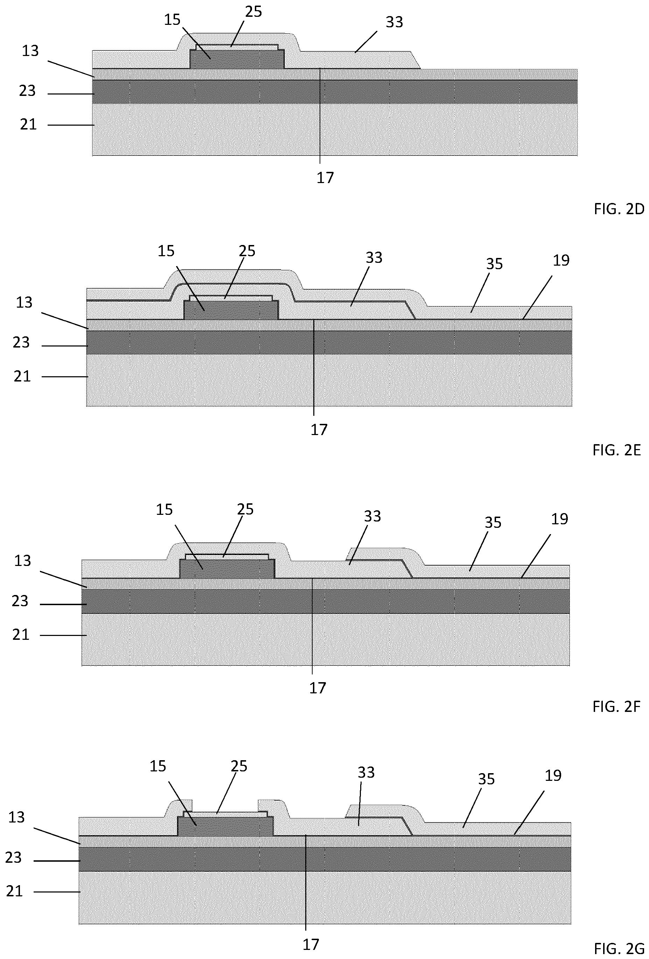

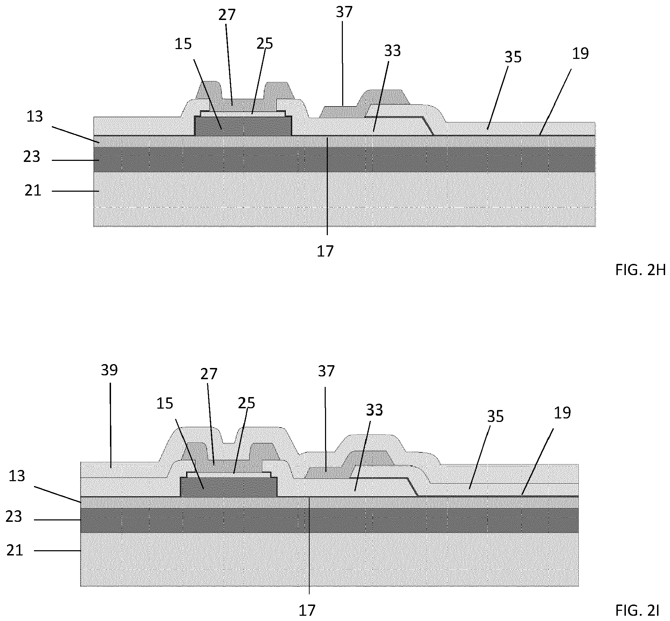

La figure 2A, la figure 2B, la figure 2C, la figure 2D, la figure 2E, la figure 2F, la figure 2G, la figure 2H et la figure 2I sont des vues en coupe illustrant des étapes successives d'un exemple d'un procédé de fabrication du transistor HEMT illustré en figure 1.

La figure 2A illustre une structure de départ comprenant, dans l'ordre, à partir de la face inférieure de la structure, le substrat 21, la deuxième couche semiconductrice 23 et la première couche semiconductrice 13. La structure de départ comprend, en outre, une couche de grille 15 surmontée de la couche métallique 25. Dans la structure de départ illustrée en figure 2A, les couches 23, 13, 15 et 25 s'étendent chacune de façon continue et avec une épaisseur sensiblement uniforme sur toute la surface supérieure du substrat 21.

La figure 2B illustre une structure obtenue à l'issue d'une étape de gravure localisée de la couche de grille 15 et de la couche métallique 25 de manière à conserver uniquement une portion de chaque couche formant l'empilement de grille du transistor de la figure 1.

Lors de cette étape on vient graver la couche métallique 25 par exemple par un procédé de gravure plasma, par exemple par un procédé de gravure plasma à base de chlore, par exemple par une gravure plasma en trichlorure de bore (BCl₃).

Lors de cette étape, on vient en outre graver la grille 15 par exemple par un procédé de gravure plasma, par exemple par un procédé de gravure plasma à base de chlore, par exemple par une gravure plasma en trichlorure de bore (BCl₃) et dioxygène (O₂).

A titre d'exemple, la grille 15 et la couche 25 sont gravées à travers un même masque. A l'issue de cette étape, la grille 15 et la couche 25 sont ainsi alignées, c'est-à-dire qu'elles ont leurs flancs alignés.

Les étapes de gravure de la grille 15 et de la couche 25 sont par exemple réalisées simultanément, c'est-à-dire qu'elles sont réalisées au sein d'une même chambre de gravure. En variante, les étapes de gravure de la grille 15 et de la couche 25 sont réalisées successivement l'une après l'autre.

La couche 25 peut, par exemple, subir une autre gravure, par exemple une gravure humide, de façon à lui retirer une partie périphérique et ainsi découvrir une partie périphérique de la face supérieure de la grille 15. Cette gravure est par exemple réalisée à travers un masque dur, par exemple en nitrure de silicium.

Ces étapes de gravure sont par exemple suivies d'une étape de nettoyage de la face supérieure de la structure de façon à retirer par exemple les résidus issus du ou des masques de gravure et les impuretées issues de la gravure de la couche 25 et de la grille 15. Le nettoyage de la structure comporte par exemple une étape de décapage ("stripping" en anglais) par plasma de dioxygène et diazote (N₂). Le nettoyage de la structure peut en outre comporter une étape de retrait des résidus organiques à l'aide d'un solvant.

La figure 2C illustre une structure obtenue à l'issue d'une étape de formation de la couche de passivation 17 et de la couche isolante 33 sur la face supérieure de la structure illustrée en figure 2B.

Lors de cette étape, on vient dans un premier temps former la couche de passivation 17 pleine plaque, de sorte qu'elle recouvre l'ensemble de la face supérieure de la structure illustrée en figure 2B.

La couche de passivation 17 est, par exemple, formée en contact avec la face supérieure de la couche semiconductrice 13, les flancs de la grille 15 et les flancs et la face supérieure de la couche 25.

La couche de passivation 17 est par exemple formée par un procédé de dépôt de couche mince, par exemple un procédé de dépôt de couche atomique ou ALD (de l'anglais "Atomic Layer Déposition"). A titre d'exemple, le procédé de dépôt de la couche de passivation 17 est assisté par plasma. A l'issue de cette étape, la couche de passivation 17 a une épaisseur par exemple comprise entre 1 nm et 10 nm, par exemple comprise entre 1,5 nm et 5 nm, par exemple de l'ordre de 2,5 nm.

Dans un second temps, on vient, dans cet exemple, former la couche isolante 33 pleine plaque, de sorte qu'elle recouvre l'ensemble de la face supérieure de la couche de passivation 17. La couche isolante 33 est par exemple formée en contact avec la couche de passivation 17. La couche isolante 33 est par exemple formée par un procédé de dépôt chimique en phase vapeur assisté par plasma ou PECVD (de l'anglais "Plasma-Enhanced Chemical Vapor Déposition"). A l'issue de cette étape, la couche isolante 33 a une épaisseur par exemple comprise entre 150 nm et 400 nm, par exemple comprise entre 200 nm et 350 nm, par exemple de l'ordre de 300 nm.

A titre d'exemple, les étapes de dépôt de la couche de passivation 17 et de la couche isolante 33 sont précédées d'une ou plusieurs étapes de préparation de la surface de la structure illustrée en figure 2B. La préparation de la surface de la structure illustrée en figure 2B peut comprendre un nettoyage consistant par exemple en un nettoyage chimique à l'aide d'acide, par exemple de chlorure d'hydrogène (HCl) et de fluorure d'hydrogène (HF). La préparation de la surface de la structure illustrée en figure 2B peut, en outre, comprendre un nettoyage consistant par exemple en une oxydation de surface. La couche de passivation 17 sera ainsi formée au contact d'un film d'oxyde, lui-même formé au contact de la face supérieure de la couche 13.

La figure 2D illustre une structure obtenue à l'issue d'une étape de gravure de la couche de passivation 19 et de la couche isolante 33.

Plus particulièrement, lors de cette étape, on vient retirer la couche de passivation 17 et la couche isolante 33 en vis-à-vis d'une partie de la couche semiconductrice 13. A titre d'exemple, les couches 17 et 33 sont conservées à côté de la grille 15, et retirées en dehors de la périphérie de la grille 15, ici dans une partie située à droite de la grille 15.

A titre d'exemple, le retrait des couches 17 et 33 est réalisé par gravure plasma, par exemple à base de fluor, par exemple à base de tétrafluorure de carbone (CF₄).

La gravure des couches 17 et 33 est par exemple sélective et ne grave pas la couche semiconductrice 13 en nitrure de gallium. La gravure des couches 17 et 33 s'arrête alors avec le dévoilement de la face supérieure de la couche 13.

Ces étapes de gravure sont par exemple suivies d'une étape de nettoyage de la face supérieure de la structure par exemple similairement à ce qui a été décrit en relation avec la figure 2B.

La figure 2E illustre une structure obtenue à l'issue d'une étape de formation de la couche de passivation 19 et de la couche isolante 35 sur la face supérieure de la structure illustrée en figure 2D.

Lors de cette étape, on vient dans un premier temps former la couche de passivation 19 pleine plaque, de sorte qu'elle recouvre l'ensemble de la face supérieure de la structure illustrée en figure 2D.

La couche de passivation 19 est, par exemple, formée en contact avec la face supérieure de la couche isolante 33 et la partie de la couche semiconductrice 13 non recouverte par la couche de passivation 17. A titre d'exemple, la couche de passivation 19 recouvre, en outre, le flanc gravé des couches 17 et 33.

La couche de passivation 19 est par exemple formée par un procédé de dépôt de couche mince, par exemple un procédé de dépôt de couche atomique ou ALD (de l'anglais "Atomic Layer Déposition"). A titre d'exemple, le procédé de dépôt de la couche de passivation 19 est assisté par plasma. A l'issue de cette étape, la couche de passivation 19 a une épaisseur par exemple comprise entre 1 nm et 10 nm, par exemple comprise entre 2 nm et 8 nm, par exemple de l'ordre de 5 nm.

Dans un second temps, on vient former la couche isolante 35 pleine plaque, de sorte qu'elle recouvre l'ensemble de la face supérieure de la couche de passivation 19. La couche isolante 35 est par exemple formée en contact avec la couche de passivation 19. La couche isolante 35 est par exemple formée par un procédé identique au procédé de formation de la couche 33 décrit en relation avec la figure 2C. A l'issue de cette étape, la couche isolante 35 a une épaisseur par exemple comprise entre 150 nm et 400 nm, par exemple comprise entre 200 nm et 350 nm, par exemple de l'ordre de 300 nm.

A titre d'exemple, les étapes de dépôt de la couche de passivation 19 et de la couche isolante 35 sont précédées d'une ou plusieurs étapes de préparation de la surface de la structure illustrée en figure 2D similairement à ce qui a été décrit en relation avec la figure 2C.

La figure 2F illustre une structure obtenue à l'issue d'une étape de gravure des couches 19 et 35 de la structure illustrée en figure 2E.

Plus particulièrement, lors de cette étape, on vient retirer la couche de passivation 19 et la couche isolante 35 en vis-à-vis de la grille 15 et en vis-à-vis d'une partie périphérique de la grille 15. En d'autres termes, lors de cette étape, on vient retirer une partie des couches 19 et 33 de sorte que, à l'issue de cette étape, la couche de passivation 19 et la couche isolante 35 recouvrent la partie de la couche semiconductrice 13 non recouverte par la couche de passivation 17, le flanc de la couche isolante 33, ici situé à droite de la grille 15, et de sorte qu'elles se prolongent sur une partie de la couche d'isolation 33 en direction de la grille 15, sans atteindre la grille 15.

A titre d'exemple, le retrait des couches 19 et 35 est réalisé par un procédé similaire au procédé de gravure des couches 17 et 33 décrit en relation avec la figure 2D.

Le retrait des couches 19 et 33 est par exemple suivi d'une étape de nettoyage de la face supérieure de la structure, par exemple similairement à ce qui a été décrit en relation avec la figure 2B.

La figure 2G illustre une structure obtenue à l'issue d'une étape d'ouverture des couches 17 et 33 en vis-à-vis de la grille 15 de la structure illustrée en figure 2F.

Plus particulièrement, lors de cette étape, on vient retirer la couche de passivation 17 et la couche isolante 33 en vis-à-vis d'une partie centrale de la face supérieure de la grille 15.

A titre d'exemple, le retrait des couches 17 et 33 est réalisé par gravure plasma, par exemple à base de fluor, par exemple à base de tétrafluorure de carbone (CF₄).

La gravure des couches 17 et 33 est par exemple non sélective par rapport à la couche 25, la gravure s'arrête alors avec le dévoilement de la face supérieure de la couche 25. Le retrait partiel des couches 17 et 33 est par exemple suivi d'une étape de nettoyage de la face supérieure de la structure, par exemple similairement à ce qui a été décrit en relation avec la figure 2B.

La figure 2H illustre une structure obtenue à l'issue d'une étape de formation de la métallisation 27 et de la région 37 sur la face supérieure de la structure illustrée en figure 2G.

Lors de cette étape, on vient par exemple former la métallisation de contact de grille 27 dans l'ouverture formée dans les couches 17 et 33 en vis-à-vis de la partie centrale de la grille 15. A titre d'exemple, la métallisation de contact de grille 27 est formée sur et en contact avec la couche 25. A titre d'exemple, lors de cette étape, on vient en outre former la région 37 simultanément sur une partie de la surface de la première couche isolante 33 et sur une partie de la surface de la deuxième couche isolante 35. La métallisation de contact de grille 27 et la région 37 sont, par exemple, formées par dépôt d'une ou plusieurs couches en un matériau métallique suivie d'une étape de gravure.

A titre d'exemple, l'étape de formation de la métallisation de contact de grille 27 et de la région 37 est précédée d'une étape de préparation de la surface de la structure illustrée en figure 2G, consistant par exemple en un nettoyage chimique à l'aide d'acide, par exemple de chlorure d'hydrogène (HCl).

La figure 2I illustre une structure obtenue à l'issue d'une étape de formation de la couche isolante 39 sur la face supérieure de la structure illustrée en figure 2H.

Lors de cette étape, on vient par exemple former la couche isolante 39 pleine plaque, de sorte qu'elle recouvre l'ensemble de la face supérieure de la structure illustrée en figure 2H, c'est-à-dire la face supérieure et les flancs de la métallisation de contact de grille 27 et de la région 37, une partie de la couche 33 et une partie de la couche 35. La couche isolante 39 est par exemple formée par un procédé identique au procédé de formation de la couche 33 décrit en relation avec la figure 2C. A l'issue de cette étape, la couche isolante 39 a une épaisseur par exemple comprise entre 150 nm et 400 nm, par exemple comprise entre 200 nm et 350 nm, par exemple de l'ordre de 300 nm.

A l'issue de cette étape, les contacts ohmiques et plus particulièrement les métallisations de contact de source 29 et de drain 31 sont, par exemple formées de façon à former la structure illustrée en figure 1.

Pour cela, des ouvertures destinées à recevoir les métallisations de contact de source 29 et de drain 31 sont, dans un premier temps, créées dans les couches 33 et 35. Les ouvertures sont par exemple formées par un procédé de gravure plasma, par exemple à base de fluor, par exemple à base de tétrafluorure de carbone (CF₄). La gravure susmentionnée est par exemple sélective et ne grave pas la couche semiconductrice 13 en nitrure de gallium. La gravure des couches 33 et 35 s'arrête ainsi lorsque la face supérieure de la couche 13 est dévoilée. L'étape de formation des ouvertures destinées à recevoir les métallisations de contact 29 et 31 est par exemple suivie d'une étape de nettoyage de la face supérieure de la structure, par exemple similairement à ce qui a été décrit en relation avec la figure 2B.

A titre d'exemple, une étape de préparation de la surface de la face supérieure de la couche 13 dans les ouvertures peut être prévue. Cette étape consiste par exemple en un nettoyage chimique à l'aide d'acide, par exemple de chlorure d'hydrogène (HCl).

Dans un second temps, les métallisations de contact de source 29 et de drain 31 sont, par exemple, formées dans les ouvertures précédemment réalisées et la région 41 est, par exemple, formée sur la face supérieure de la couche 39. Les métallisations 29, 31 et la région 41 sont, par exemple, formées par dépôt d'une ou plusieurs couches en un matériau métallique suivie d'une étape de gravure.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, on peut prévoir que les métallisations de contact ohmique, par exemple les métallisations de contact de source et de drain, soient formées avant la formation de la métallisation de contact de grille.

Par ailleurs, bien que les modes de réalisation et de mise en oeuvre aient été décrits avec une couche de passivation 19 en nitrure d'aluminium, ils ne se limitent pas à cet exemple particulier, la couche de passivation 19 pouvant être en un autre matériau diélectrique porteur de charges positives.

En outre, bien que l'on ait décrit ci-dessus un exemple de réalisation dans lequel la grille 15 du transistor est en contact avec la face supérieure de la couche semiconductrice supérieure 13, à titre de variante, la grille 15 peut être séparée de la couche semiconductrice 13 par une couche d'isolant de grille.

Enfin, les modes de réalisation ne se limitent pas aux exemples de valeurs numériques ni aux exemples de matériaux mentionnés dans la présente description.

Enfin, la mise en oeuvre pratique des modes de réalisation et variantes décrits est à la portée de la personne du métier à partir des indications fonctionnelles données ci-dessus.

## Revendications

1. Transistor HEMT comportant :
- une première couche semiconductrice (13) ;
- une grille (15) disposée sur une première face de la première couche semiconductrice (13) ;
- une première couche de passivation (17) en un premier matériau sur les flancs de la grille, la première couche de passivation se prolongeant en outre sur une première partie de ladite face de la première couche semiconductrice ; et
- une deuxième couche de passivation (19) en un deuxième matériau différent du premier matériau sur une deuxième partie de ladite face de la première couche semiconductrice à côté de la première couche de passivation,
dans lequel la première couche de passivation (17) a une épaisseur comprise entre 1 et 10 nm, et la deuxième couche de passivation (19) a une épaisseur comprise entre 1 et 10 nm.

2. Transistor selon la revendication 1, dans lequel la première couche semiconductrice (13) est à base de nitrure de gallium.

3. Transistor selon la revendication 2, dans lequel la première couche semiconductrice (13) est en nitrure d'aluminium-gallium.

4. Transistor selon l'une quelconque des revendications 1 à 3, dans lequel la première couche de passivation (17) est en alumine.

5. Transistor selon l'une quelconque des revendications 1 à 4, dans lequel la deuxième couche de passivation (19) est en nitrure d'aluminium.

6. Transistor selon l'une quelconque des revendications 1 à 5, comportant une deuxième couche semiconductrice (23) en contact avec une deuxième face de la première couche semiconductrice (13), opposée à la première face.

7. Transistor selon la revendication 6, dans lequel la deuxième couche semiconductrice (23) est en nitrure de gallium.

8. Transistor selon l'une quelconque des revendications 1 à 7, comportant une métallisation de contact de source (29) et une métallisation de contact de drain (31), disposées respectivement de part et d'autre de la grille (15).

9. Transistor selon la revendication 8, dans lequel la couche de passivation (17) s'étend latéralement depuis la grille (15) en direction de la métallisation de contact de drain (31), sur une partie seulement de la surface entre la grille (15) et la métallisation de contact de drain (31).

10. Transistor selon la revendication 8 ou 9, dans lequel la couche de passivation (17) s'étend latéralement depuis la grille (15) jusqu'à la métallisation de contact de source (29).

11. Transistor selon l'une quelconque des revendications 8 à 10, dans lequel la deuxième couche de passivation (19) s'étend latéralement depuis un bord de la première couche de passivation (17) situé entre la grille (15) et la métallisation de contact de drain (31), jusqu'à la métallisation de contact de drain (31).

12. Transistor selon l'une quelconque des revendications 1 à 11, dans lequel la première couche de passivation (17) est recouverte d'une couche d'isolation (33).

13. Transistor selon la revendication 12, dans lequel la deuxième couche de passivation (19) recouvre le flanc de la couche isolante (33) situé entre la grille (15) et la métallisation de contact de drain (31) et se prolonge sur une partie de la couche d'isolation (33) en direction de la grille (15).

14. Procédé de formation d'un transistor HEMT comportant les étapes successives suivantes :
a) former une première couche semiconductrice (13) ;
b) former une grille (15) sur une première face de la première couche semiconductrice (13) ;
c) former, par dépôt ALD, une première couche de passivation (17) en un premier matériau sur les flancs de la grille, la première couche de passivation se prolongeant en outre sur une première partie de ladite face de la première couche semiconductrice ; et
d) former, par dépôt ALD, une deuxième couche de passivation (19) en un deuxième matériau différent du premier matériau sur une deuxième partie de ladite face de la première couche semiconductrice à côté de la première couche de passivation.
